# EUROPEAN PATENT APPLICATION

(11) **EP 1 656 007 A1**
(43) Date of publication of application: **10.05.2006**
(21) Application number: 05022766.9
(22) Date of filing: 19.10.2005
(51) Int. Cl.: H05K 5/00

(54) **System for managing inventory information about a printed circuit board**

(30) Priority: 04.11.2004 JP 2004320125
(71) Applicant: EVOLIUM SAS, 75008 Paris (FR)
(72) Inventor: Sakaguchi, Hiroyuki, Kanagawa (JP)
(74) Representative: Brose, Gerhard

(57) **Abstract**

[Problem] To provide a management system for managing inventory information about a printed circuit board, capable of reading and writing inventory information about the printed circuitboard, whether the printed circuit board is mounted on an apparatus and operating normally, or the printed circuit board exists alone or the printed circuit board or the apparatus is not operating normally.

[Solving Means] A printed circuit board includes a wireless ID tag having a contact interface, a non-contact interface, and storing means for storing inventory information, and the inventory information can be read and written by an apparatus on which the printed circuit board is mounted by way of the contact interface, or by non-contact communication means by way of the non-contact interface.

## Description

### [Technical Field]

The present invention relates to a management system for managing inventory information about a board, namely a printed circuit board, mounted on an apparatus.

### [Background Art]

An apparatus of a large scale such as a router, a communication control unit, or a plant control unit has a plurality of printed circuit boards. The plurality of printed circuit boards are generally contained on shelves, and the plurality of shelves are contained in frames.

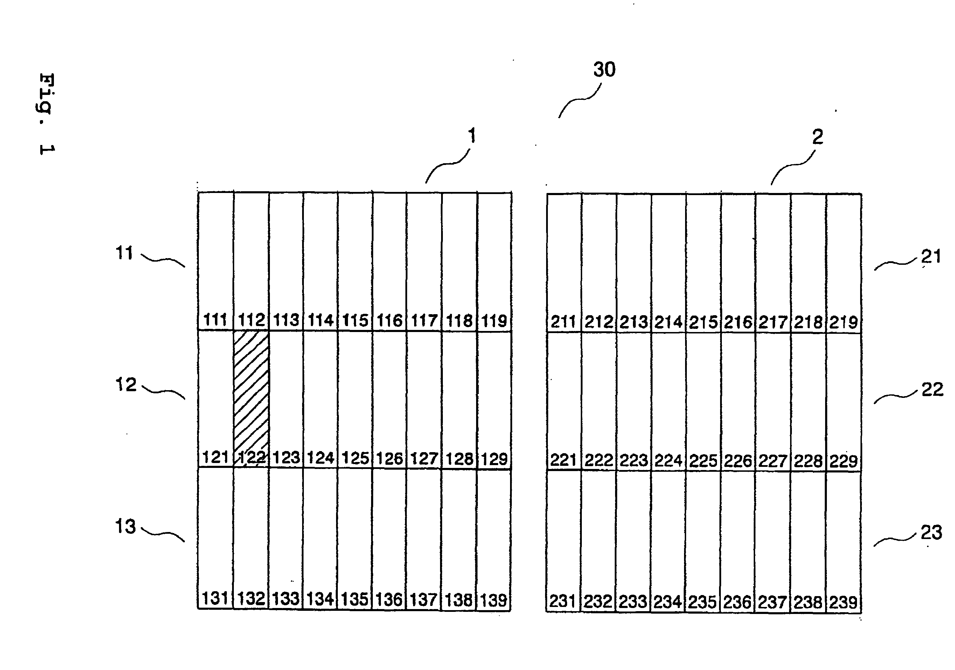

Fig. 1 shows an example of such apparatus 30. The apparatus 30 shown in Fig. 1 has frames 1 and 2. The frame 1 has a plurality of shelves 11, 12, and 13, and the frame 2 has a plurality of shelves 21, 22, and 23. The shelf 11 has plurality of slots 111 to 119 for mounting printed circuit boards. Similarly, the shelves 12 to 23 have a plurality of slots for mounting printed circuit boards respectively.

These printed circuit boards have inventory information about each printed circuit board. The inventory information includes, for example, a manufacturing date, a manufacturing serial number, a drawing number, a version number, a name, a date of mounting, a final maintenance date, or an actual mounting position showing the mounting position on the apparatus of the printed circuit board. As for the mounting position, for example, the mounting position of the printed circuit board indicated by shaded area in Fig. 1 is (1, 12, 122), which shows the position of the slot 122 of the shelf 12 of the frame 1. Such inventory information is referred to and confirmed when managing the stock of printed circuit boards, mounting the printed circuit board on an apparatus, checking or replacing the printed circuit board, or repairing the printed circuit board.

Hitherto, such inventory information has been written into an internal memory of the printed circuit board, or marked on a seal, which is adhered to the surface of the printed circuit board, by handwriting or barcode.

### [Disclosure of the Invention]

### [Problems that the Invention Is to Solve]

When the inventory information is written in the internal memory of the printed circuit board, if the printed circuit board does not operate normally, for example, the printed circuit board is defective, neither the inventory information stored in the internal memory can be read, nor the inventory information can be written into the internal memory. That is, when the printed circuit board fails to operate normally, such trouble cannot be handled by referring to and confirming the inventory information such as the manufacturing date, the manufacturing serial number, the drawing number, the version number, the name, the date of mounting, the final maintenance date, or the actual mounting position of the printed circuit board, by reading out from the internal memory.

Further, when the apparatus in which the printed circuit board is mounted does not operate normally, even if the printed circuit board operates normally, the inventory information written in the internal memory of the printed circuit board cannot be read out through the apparatus. Or when the printed circuit board is not mounted on the apparatus, for example, when the printed circuit board exists alone and power is not supplied in the state of stock or distribution, a special device is needed to read out the inventory information written in the internal memory of the printed circuit board.

When a seal marking the inventory information by handwriting or barcode is adhered to the printed circuit board, the inventory information marked on the seal cannot be read or written by the apparatus side, that is, it cannot be managed.

To solve such problems, by using both internal memory and seal for inventory information, when the printed circuit board and the apparatus are operating normally, the inventory information stored in the internal memory of the printed circuit board is used, or when the printed circuit board or the apparatus does not operate normally, or the printed circuit board exists alone, the inventory information marked on the seal adhered to the printed circuit board is used, and in such method, it is required to manage so that the inventory information stored in the internal memory and the inventory information marked on the seal may coincide with each other, and it has been difficult to realize such managing method.

It is hence an object of the invention to present a management system for managing inventory information about printed circuit board capable of reading and writing inventory information about printed circuit board, whether the printed circuit board is mounted on the apparatus and the printed circuit board and the apparatus are operating normally, or the printed circuit board is not mounted on the apparatus or the printed circuit board is mounted on the apparatus but the printed circuit board or the apparatus is not operating normally.

### [Means for Solving the Problems]

The invention according to claim 1 is a management system for managing inventory information about a printed circuit board mounted on an apparatus comprising:
a printed circuit board having a wireless ID tag including a contact interface, a non-contact interface, and storing means for storing inventory information about the printed circuit board,
an apparatus mounting the printed circuit board and communicating with the wireless ID tag by way of the contact interface, and
non-contact communication means communicating with the wireless ID tag by way of the non-contact interface,
in which when the printed circuit board is mounted on the apparatus, and both the printed circuit board and the apparatus operate normally, the apparatus communicates with the wireless ID tag by way of the contact interface, and reads or writes inventory information about the printed circuit board stored in the storing means of the wireless ID tag, or
when the printed circuit board is not mounted on the apparatus, or if the printed circuit board is mounted on the apparatus, but when either the printed circuit board or the apparatus does not operate normally, the non-contact communication means communicates with the wireless ID tag by way of the non-contact interface, and reads or writes inventory information about the printed circuit board stored in the storing means of the wireless ID tag.

In such configuration, when the printed circuit board is mounted on the apparatus, and both the printed circuit board and the apparatus operate normally, the apparatus can read or write inventory information about the printed circuit board stored in the storing means of the wireless ID tag, by way of the contact interface. Further when the printed circuit board is not mounted on the apparatus, or if the printed circuit board is mounted on the apparatus, but when either the printed circuit board or the apparatus does not operate normally, the non-contact communication means can read or write inventory information about the printed circuit board stored in the storing means of the wireless ID tag, by way of the non-contact interface.

In the invention according to claim 2, when the printed circuit board is mounted on the apparatus, and both the printed circuit board and the apparatus operate normally, the apparatus writes information about an actual mounting position of the printed circuit board when the printed circuit board is mounted on the apparatus, into the storing means of the wireless ID tag by way of the contact interface.

In such configuration, when the printed circuit board is mounted on the apparatus, and both the printed circuit board and the apparatus operate normally, the actual mounting position of the printed circuit board is written into the storing means of the wireless ID tag as one piece of inventory information automatically when the printed circuit board is mounted on the apparatus. Therefore, the information about the actual mounting position of the printed circuit board can be easily read out from the storing means of the wireless ID tag, and checked whether or not to coincide with the predetermined mounting position.

In the invention according to claim 3, the inventory information stored in the storing means of the wireless ID tag includes at least one of a manufacturing date, a manufacturing serial number, a drawing number, a version number, a name, a date of mounting, a final maintenance date, and the actual mounting position of the printed circuit board.

In such configuration, the necessary inventory information about the printed circuit board can be easily referred to and confirmed when managing the stock of printed circuit boards, mounting the printed circuit board on an apparatus, checking or replacing the printed circuit board, or repairing the printed circuit board. [Best Mode for Carrying Out the Invention]

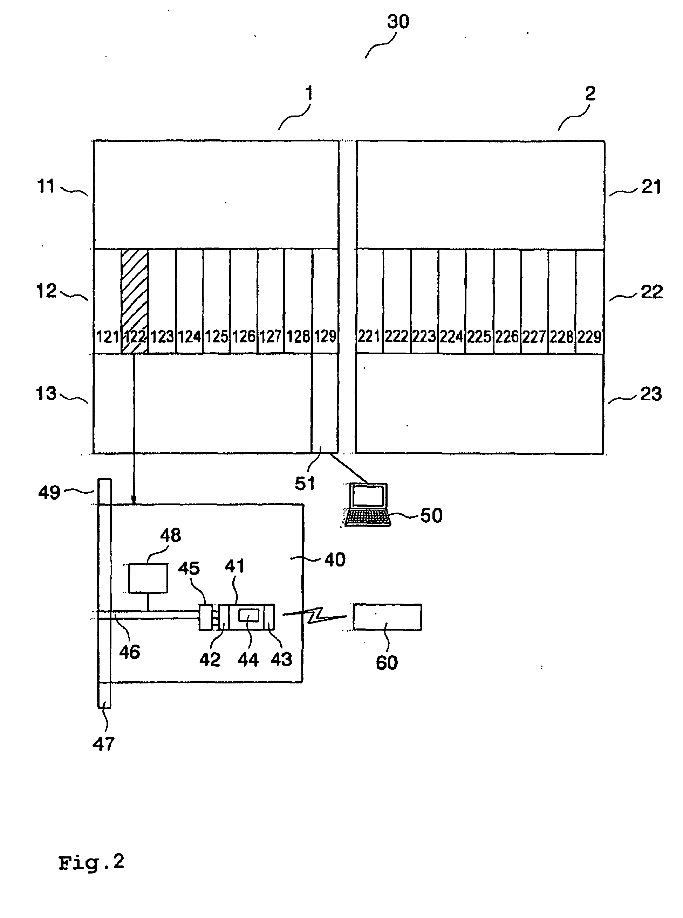

Fig. 2 is a schematic diagram of management system for managing inventory information about a printed circuit board of the invention.

Same as the apparatus shown in Fig. 1, the apparatus 30 has frames 1 and 2. The frame 1 has a plurality of shelves 11, 12, and 13, and the frame 2 has a plurality of shelves 21, 22, and23. The shelf 12 has plurality of slots 121 to 129 for mounting printed circuit boards. Similarly, other shelves 11, 13, 21, 22, and 23 have a plurality of slots for mounting printed circuit boards respectively. To clarify the drawing, slots are shown only in shelves 12 and 22.

The printed circuit board 40 mounted on the slot 122 of the shelf 12 of the frame 1 indicated by shaded area in Fig. 2 is shown in the lower part of Fig. 2.

This printed circuit board 40 has a wireless ID tag 41. The wireless ID tag 41 includes a contact interface 42, a non-contact interface 43, and storing means 44. The wireless ID tag 41 is composed of a reader-writer (including an antenna and a controller) and an ID tag capable of storing information in an electronic circuit, and the wireless ID tag 41 can transmit and receive data by wireless communications, and can also transmit and receive data through a contact type connection unit.

The contact interface 42 is connected to a tag interface unit 45. The tag interface unit 45 is connected to a back panel 47 by way of a link 46 to an apparatus control unit 51. The back panel 47 is connected to the apparatus control unit 51 mounted on the slot 139 of the shelf 13 of the frame 1. The apparatus control unit 51 is connected to an operation terminal unit 50 of the apparatus 30. Thus, the wireless ID tag 41 can communicate with the operation terminal unit 50 of the apparatus 30 by way of the contact interface 42, the tag interface unit 45, the link 46 to the apparatus control unit 51, the back panel 47, and the apparatus control unit 51.

The wireless ID tag 41 can also communicate with non-contact communication means 60 through the non-contact interface 43.

The storing means 44 of the wireless ID tag 42 stores the inventory information about the printed circuit board 40 provided with this wireless ID tag 42.

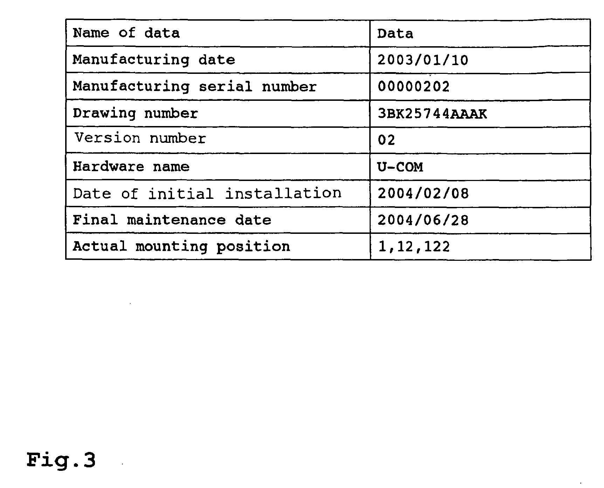

Fig. 3 shows an example of inventory information stored in the storing means 44 of the wireless ID tag 42. The inventory information shown in Fig. 3 includes the manufacturing date (2003/01/10), the manufacturing serial number (00000202), the drawing number (3BK25744AAAK), the version number (02), the hardware name (U-COM), the date of initial installation (2004/02/08), the final maintenance date (2004/06/28), and the actual mounting position (1, 12, 122) of the printed circuit board 40.

The following explanation relates to a method of reading the inventory information about the printed circuit board 40 from the storing means 44 of the wireless ID tag 41, and a method of writing the inventory information into the storing means 44 of the wireless ID tag 41.

When the printed circuit board 40 is mounted on the apparatus 30, and the printed circuit board 40 and the apparatus 30 both operate normally, the operation terminal unit 50 of apparatus 30 reads inventory information about the printed circuit board 40 stored in the storing means 44 of the wireless ID tag 41 by way of the contact interface 42, or writes inventory information about the printed circuit board 40 into the storing means 44 of the wireless ID tag 41.

That is, when reading inventory information about the printed circuit board 40 from the storing means 44 of the wireless ID tag 41, the operation terminal unit 50 of the apparatus 30 can read stored inventory information from the storing means 44 of the wireless ID tag 41 provided in the printed circuit board 40, by way of the apparatus control unit 51, the back panel 47, the link 46 to the apparatus control unit 51, the tag interface unit 45, and the contact interface 42. On the other hand, when writing inventory information about the printed circuit board 40 into the storing means 44 of the wireless ID tag 41, the operation terminal unit 50 of the apparatus 30 can write inventory information into the storing means 44 of the wireless ID tag 41 provided in the printed circuit board 4 0, byway of the apparatus control unit 51, the back panel 47, the link 46 to the apparatus control unit 51, the tag interface unit 45, and the contact interface 42.

When the printed circuit board 40 is mounted on the apparatus 30, the CPU 48 of the printed circuit board 40 can read out the actual mounting position of the printed circuit board 40 as one of the inventory information from the back panel 47 through the link 46, and can automatically write into the storing means 44 of the wireless ID tag 41 provided in the printed circuit board 40 by way of the tag interface unit 45 and the contact interface 42. The back panel 47 has a circuit 49 for identifying the mounting position in each slot.

When the printed circuit board 40 is not mounted on the apparatus 30, that is, when the printed circuit board 40 exists alone, or if the printed circuit board 40 is mounted on the apparatus 30, but when either the printed circuit board 40 or the apparatus 30 does not operate normally, the non-contact communication means 60 can read inventory information about the printed circuit board 40 from the storing means 44 of the wireless ID tag 41 by way of the non-contact interface 43, or can write inventory information about the printed circuit board 40 into the storing means 44 of the wireless ID tag 41 by way of the non-contact interface 43.

Thus, the management system for managing inventory information about a printed circuit board of the invention can read and write inventory information about the printed circuit board, whether the printed circuit board is mounted on the apparatus, and the printed circuit board and the apparatus are operating normally, or the printed circuit board is not mounted on the apparatus or the printed circuit board is mounted on the apparatus but the printed circuit board or the apparatus is not operating normally. Therefore, such inventory information of printed circuit boards can be easily referred to or confirmed when managing a stock of the printed circuit boards, mounting the printed circuit board on the apparatus, checking or replacing the printed circuit board, or repairing the printed circuit board.

### [Brief Description of the Drawings]

Fig. 1 shows an apparatus including a plurality of printed circuit boards.
Fig. 2 is a block diagram of management system for managing inventory information about a printed circuit board of the invention.
Fig. 3 shows an example of inventory information relating to printed circuit board.
[Description of reference numerals]

- 1, 2: Frame
- 11 to 23: Shelf
- 30: Apparatus
- 40: Printed circuit board
- 41: Wireless ID tag
- 42: Contact interface
- 43: Non-contact interface
- 44: Storing means
- 45: Tag interface unit
- 46: Link
- 47: Back panel
- 48: CPU in board
- 49: Mounting position identifying circuit
- 50: Operation terminal unit
- 51: Apparatus control unit
- 60: Non-contact communication means
- 111 to 239: Slot

## Claims

1. A management system for managing inventory information about a printed circuit board mounted on an apparatus comprising:
a printed circuit board having a wireless ID tag including a contact interface, a non-contact interface, and storing means for storing inventory information about the printed circuit board,
an apparatus mounting the printed circuit board and communicating with the wireless ID tag by way of the contact interface, and
non-contact communication means communicating with the wireless ID tag by way of the non-contact interface,
wherein when the printed circuit board is mounted on the apparatus, and both the printed circuit board and the apparatus operate normally, the apparatus communicates with the wireless ID tag by way of the contact interface, and reads or writes inventory information about the printed circuit board stored in the storing means of the wireless ID tag, or
when the printed circuit board is not mounted on the apparatus, or if the printed circuit board is mounted on the apparatus, but when either the printed circuit board or the apparatus does not operate normally, the non-contact communication means communicates with the wireless ID tag by way of the non-contact interface, and reads or writes inventory information about the printed circuit board stored in the storing means of the wireless ID tag.

2. The management system according to claim 1, wherein when the printed circuit board is mounted on the apparatus, and both the printed circuit board and the apparatus operate normally, the apparatus writes information about an actual mounting position of the printed circuit board when the printed circuit board is mounted on the apparatus, into the storing means of the wireless ID tag by way of the contact interface.

3. The management system according to claim 2, wherein the inventory information stored in the storing means of the wireless ID tag includes at least one of a manufacturing date, a manufacturing serial number, a drawing number, a version number, a name, a date of mounting, a final maintenance date, and the actual mounting position of the printed circuit board.
